# EUROPEAN PATENT APPLICATION

(11) **EP 4 328 019 A1**
(43) Date of publication of application: **28.02.2024**
(21) Application number: 22791361.3
(22) Date of filing: 22.02.2022
(51) Int. Cl.: B32B 27/00, B32B 27/18, C08K 5/56, C08L 83/05, C08L 83/07, C08K 3/22, B32B 7/027

(54) **THERMALLY CONDUCTIVE COMPOSITE SHEET AND METHOD FOR MOUNTING HEAT-GENERATING ELECTRONIC COMPONENT**

(30) Priority: 19.04.2021 JP 2021070317
(71) Applicant: SHIN-ETSU CHEMICAL CO., LTD., Tokyo 1000005 (JP)
(72) Inventor: ISHIHARA Yasuhisa, Annaka-shi, Gunma 379-0224 (JP); ENDO Akihiro, Annaka-shi, Gunma 379-0224 (JP); YODA Masahiro, Annaka-shi, Gunma 379-0127 (JP)
(74) Representative: Sonnenhauser, Thomas Martin
(86) International application number: PCT/JP2022/007151
(87) International publication number: WO 2022/224579

(57) **Abstract**

The present invention is a thermally conductive composite sheet, including: a thermally conductive sheet containing an organopolysiloxane elastomer and a thermally conductive filler, and having an Asker C hardness of 30 or less, surface tack force of 30 gf or more, a thickness of 0.3 mm or more, and a thermal conductivity of 0.8 W/mK or more; and an insulative resin film having a thickness of 10 um or more and 50 um or less and an elastic modulus of 1 GPa or more, wherein the insulative resin film is laminated on one side of the thermally conductive sheet. This provides a thermally conductive composite sheet which has high surface slidability so that a heat-generating electronic component can be easily mounted thereon, and also has excellent thermal conductivity.

## Description

### TECHNICAL FIELD

The present invention relates to a thermally conductive composite sheet and a method for mounting a heat-generating electronic component.

### BACKGROUND ART

Accompanying the high performance, high speeds, miniaturization, and high integration of LSI chips such as a CPU, a driver IC, and memory which are used in electronic devices such as personal computers and mobile phones, a large amount of heat is produced by the chips themselves, and the increase in temperature of the chip due to the heat causes malfunction or destruction of the chip. In recent years, it is necessary to take a measure against heat also in a battery of an electric car. Therefore, numerous heat dissipation methods and heat dissipation members used therein have been proposed for suppressing the increase in temperature of the chips.

When there is some space between a heat-generating electronic component and a cooling component such as a heat sink or housing, a thermally conductive sheet is often used. In addition, an electrically insulated condition should be ensured between a heat-generating element (heat-generating electronic component) and the heat sink or housing in many cases, so that the thermally conductive sheet, also, often requires to have the insulation property. In many of such cases, for absorbing thickness tolerance between the heat-generating electronic component and the cooling component such as a heat sink or housing, thickness of the thermally conductive sheet is increased and further the hardness is set to be low. Thereby, it is possible to efficiently absorb component tolerance, and further reduce stress when compressed.

A typical method for mounting the thermally conductive sheet includes attaching the thermally conductive sheet on the cooling component, and then placing the heat-generating electronic component onto the thermally conductive sheet from the vertical direction to fix the component by applying pressure with a screw or the like.

However, in some cases, it is difficult to place the heat-generating electronic component onto the thermally conductive sheet from the vertical direction due to a mounting process condition or a structure of the heat-generating electronic component. In such a case, it may be necessary to mount the heat-generating electronic component by sliding on the thermally conductive sheet after the thermally conductive sheet is placed on the cooling component. However, since a general thermally conductive sheet is soft, when trying to slide the heat-generating electronic component on the sheet, the thermally conductive sheet may be deformed or broken. This is because the thermally conductive sheet is soft and therefore the strength is insufficient, and has poor slidability due to having sense of tackiness on the sheet surface owing to its softness. The problem due to the mounting process condition or the structure of the heat-generating electronic component includes, for example, a case where the electronic device has a complicated structure so that the direction of mounting the heat-generating electronic component is limited, and a case where the direction of applying stress is limited in mounting of the heat-generating electronic component because of a structural problem of the component. In such cases, for placing the heat-generating electronic component, it is necessary to slide the heat-generating electronic component on the thermally conductive sheet after the sheet is attached to the cooling component.

For improving the slidability, surface friction should be decreased. In silicone materials, it is known that by adding poorly soluble oil that is not involved in the rubber crosslinked structure, the oil bleeds out on the surface of the sheet so that a friction coefficient can be decreased (Patent Document 1). However, since the thermally conductive sheet is soft and has sense of tackiness, this is not effective. Further, a method for decreasing the friction coefficient by adjusting the content of an alkenyl group in a silicone-based polymer is known, but this method is applied for a millable type silicone rubber material, and it is difficult to make a cured sheet soft (Patent Document 2).

Alternatively, a method of laminating a rubber sheet with high hardness on one side of a low hardness sheet (Patent Document 3) can be considered. However, the rubber sheet is scraped off when a heat-generating electronic component is slid thereon.

Also, a method of dusting powders on the sheet surface can be considered. Dusting of powders surely improves the sliding property of the sheet surface, but this effect is only temporary, and gradually reduced. Further, the strength of the sheet surface does not change, so that break of the sheet cannot be avoided.

### CITATION LIST

### PATENT LITERATURE

Patent Document 1: JP 2009-185254 A
Patent Document 2: JP 2016-164281 A
Patent Document 3: JP 2019-071380 A

### SUMMARY OF INVENTION

### TECHNICAL PROBLEM

The present invention was made in view of the above-mentioned circumstances, and has for its object to provide a thermally conductive composite sheet which has high surface slidability so that a heat-generating electronic component can be easily mounted thereon, and also has excellent thermal conductivity.

### SOLUTION TO PROBLEM

For solving the above problems, the present invention provides a thermally conductive composite sheet, comprising:
a thermally conductive sheet containing an organopolysiloxane elastomer and a thermally conductive filler, and having an Asker C hardness of 30 or less, surface tack force of 30 gf (0.294 N) or more, a thickness of 0.3 mm or more, and a thermal conductivity of 0.8 W/mK or more; and
an insulative resin film having a thickness of 10 um or more and 50 um or less and an elastic modulus of 1 GPa or more,
wherein the insulative resin film is laminated on one side of the thermally conductive sheet.

Such a thermally conductive composite sheet has high surface slidability so that a heat-generating electronic component can be easily mounted thereon, and also has excellent thermal conductivity.

The above insulative resin film is preferably a polyester resin film.

Such a film is easily available, and also the cost can be suppressed.

Further, a thermal conductivity of the above thermally conductive composite sheet is preferably 3.0 W/mK or more.

Such a sheet can more efficiently transfer heat generated by the heat-generating electronic component to a cooling member.

In addition, the above thermally conductive sheet is preferably a cured product of a thermally conductive silicone composition containing following components (A) to (D):
(A) 100 parts by mass of an organopolysiloxane having two or more alkenyl groups in one molecule;
(B) an organohydrogen polysiloxane having two or more hydrogen atoms directly bonded to silicon atoms in such an amount that a molar number of the hydrogen atom directly bonded to the silicon atom is 0.1 to 5.0 times a molar number of the alkenyl group derived from the component (A);
(C) 1,200 to 6,500 parts by mass of the thermally conductive filler; and
(D) 0.1 to 2,000 ppm of a platinum group metal-based curing catalyst relative to the component (A) in terms of mass of a platinum group metal element.

The cured product of such a composition can be suitably used as a thermally conductive sheet.

Further, the thermally conductive filler of the component (C) preferably comprises following three components:
(C-i) 500 to 1,500 parts by mass of irregular-shaped alumina with an average particle diameter of 10 to 30 um;
(C-ii) 150 to 4,000 parts by mass of spherical alumina with an average particle diameter of 30 to 85 µm; and
(C-iii) 500 to 2,000 parts by mass of an insulative inorganic filler with an average particle diameter of 0.1 to 6 µm.

By using the component (C) in the above blending ratio, the effect of the present invention described above can be achieved more advantageously and surely.

Furthermore, the above component (C) is preferably a treated filler with one or more of following (F) surface treatment agents selected from a group consisting of:
(F-1) an alkoxysilane compound represented by the following general formula (1),

   R¹ₐR²_{b}Si(OR³)_{4-a-b} (1)
wherein R¹ independently represents an alkyl group having 6 to 15 carbon atoms, R² independently represents a monovalent hydrocarbon group having 1 to 12 carbon atoms, R³ independently represents an alkyl group having 1 to 6 carbon atoms, "a" represents an integer of 1 to 3, and "b" represents an integer of 0 to 2, provided that "a+b" is an integer of 1 to 3; and
(F-2) a dimethyl polysiloxane with one molecular chain end blocked with a trialkoxysilyl group represented by the following general formula (2), 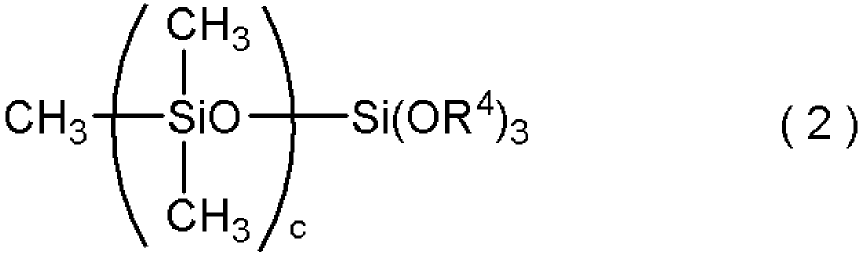
wherein R⁴ independently represents an alkyl group having 1 to 6 carbon atoms, and "c" represents an integer of 5 to 100.

By hydrophobization treatment of the component (C) with the component (F) described above, wettability between the component (C) and the organopolysiloxane of the component (A) is improved, and the thermally conductive filler of the component (C) can be uniformly dispersed in a matrix comprised of the component (A).

Additionally, an amount of the above component (F) blended is preferably 0.01 to 300 parts by mass relative to 100 parts by mass of the above component (A).

Such a ratio does not induce oil separation.

Further, the present invention provides a method for mounting a heat-generating electronic component, comprising sliding the heat-generating electronic component on the insulative resin film of the thermally conductive composite sheet described above to align at an objective position, and then fixing the heat-generating electronic component.

In such a method for mounting a heat-generating electronic component, it is possible to mount the heat-generating electronic component by sliding without causing peeling or breakage of a thermally conductive sheet when the heat-generating electronic component in an electronic device is mounted since one side of the sheet has excellent slidability. Thus, the range of the mounting method can be extended.

### ADVANTAGEOUS EFFECTS OF INVENTION

According to the present invention, for example, when mounting a heat-generating electronic component in an electronic device, it is possible to mount the heat-generating electronic component by sliding since one side of the thermally conductive sheet has excellent slidability. Specifically, the thermally conductive composite sheet comprises the thermally conductive sheet and the insulative resin film laminated on one side of the sheet; the thermally conductive sheet contains a silicone polymer and the thermally conductive filler, and has an Asker C hardness of 30 or less, surface tack force of 30 gf or more, a thickness of 0.3 mm or more, and a thermal conductivity of 0.8 W/mK or more; and the insulative resin film has a thickness of 10 um or more and 50 um or less and an elastic modulus of 1 GPa or more, so that the thermally conductive sheet has excellent slidability on one side. Therefore, peeling or breakage of the thermally conductive composite sheet is not caused even when a heat-generating component is slid on the sheet, so that a range of the mounting method can be extended, and also increase in thermal resistance can be suppressed to the utmost.

### BRIEF DESCRIPTION OF DRAWINGS

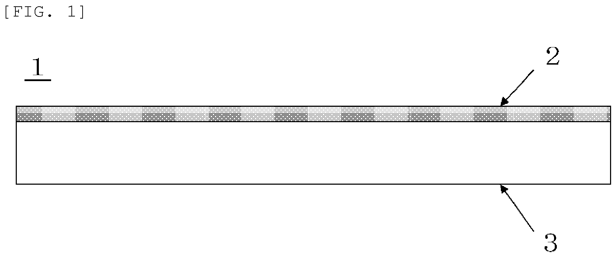

FIG. 1 is a schematic illustration of the thermally conductive composite sheet according to the present invention.

### DESCRIPTION OF EMBODIMENTS

As described above, it has been demanded to develop a thermally conductive composite sheet which has high surface slidability so that a heat-generating electronic component can be easily mounted thereon, and also has excellent thermal conductivity.

Thus, the present inventors made intensive investigations, and found that the slidability is improved by laminating the insulative resin film having a thickness of 10 um or more and 50 um or less and an elastic modulus of 1 GPa or more on one side of a thermally conductive sheet, and a heat-generating electronic component can be mounted by sliding without damaging a surface of the thermally conductive sheet.

That is, the present invention is a thermally conductive composite sheet, comprising:
a thermally conductive sheet containing an organopolysiloxane elastomer and a thermally conductive filler, and having an Asker C hardness of 30 or less, surface tack force of 30 gf (0.294 N) or more, a thickness of 0.3 mm or more, and a thermal conductivity of 0.8 W/mK or more; and
an insulative resin film having a thickness of 10 um or more and 50 um or less and an elastic modulus of 1 GPa or more,
wherein the insulative resin film is laminated on one side of the thermally conductive sheet.

Hereinafter, the present invention will be described in detail. However, it should be noted that the present invention is not limited thereto.

### Thermally Conductive Composite Sheet

The thermally conductive composite sheet of the present invention is, for example, as shown in Fig. 1. In a thermally conductive composite sheet 1 of Fig. 1, an insulative resin film 2 is laminated on one side of a thermally conductive sheet 3. The thermally conductive composite sheet 3 serves to impart thermal conductivity to the thermally conductive composite sheet 1. The insulative resin film 2 serves to impart slidability on a surface to which the insulative resin film 2 is laminated.

### Thermally Conductive Sheet

The thermally conductive sheet is not particularly limited as long as the hardness, surface tack force, thickness, and thermal conductivity are within the below-mentioned range. For example, a cured product which is obtained by curing the thermally conductive silicone composition described below into a sheet can be used. Also, a commercially available thermally conductive sheet can be used.

### Hardness of Thermally Conductive Sheet

The thermally conductive sheet is characterized to have a hardness of 30 or less and preferably 20 or less, as measured by an Asker C durometer with the method described in Appendix 2 of JIS K 7312:1996. The lower limit of the hardness is not particularly limited, and may be preferably 1 or more, more preferably 5 or more. The thermally conductive sheet having the hardness over 30 makes it difficult to compress when a heat-generating electronic component is fixed onto the sheet, so that stress is applied to the heat-generating electronic component, which may cause a damage.

### Thickness of Thermally Conductive Sheet

The thermally conductive sheet is characterized to have a thickness of 0.3 mm or more, and preferably 0.4 mm or more. The upper limit of the thickness is not particularly limited, and may be, for example, 5 mm or less, preferably 3 mm or less, and more preferably 2 mm or less. If the thickness is less than 0.3 mm, it is often difficult to absorb the tolerance of an electronic component, as described above.

### Surface Tack Force of Thermally Conductive Sheet

The thermally conductive sheet is characterized to have surface tack force of 30 gf (0.294 N) or more, and preferably 60 gf (0.588 N) or more. The upper limit of the tack force is not particularly limited, and may be preferably 500 gf (4.903 N) or less, more preferably 200 gf (1.961 N) or less, and further preferably 100 gf (0.981 N) or less. When the tack force is less than 30 gf (0.294 N), it is difficult to sufficiently adhere the thermally conductive sheet to an adherend. Also, when the insulative resin film is laminated thereon, the sheet is easily peeled off from the film. In the present invention, the tack force may be a value measured by using a constant pressure infiltration method with a tackiness tester (manufactured by Malcolm Co., Ltd.).

### Thermal Conductivity of Thermally Conductive Sheet

The thermal conductivity of the thermally conductive sheet is 0.8 W/mK or more. Preferably, it is 1.5 W/mK or more, and more preferably 3.0 W/mK or more. The upper limit of the thermal conductivity is not particularly limited, and may be 10 W/mK or less, preferably 5 W/mK or less, for example. If the thermal conductivity is less than 0.8 W/mK, heat generated from a heat-generating electronic component cannot be efficiently transferred to a cooling member. In the present invention, the thermal conductivity may be a value measured by using a hot disc method.

### Insulative Resin Film

The insulative resin film refers to a film obtained by shaping an organic resin into a film shape, and having an organic skeleton and the increased molecular weight by a polymerization reaction. Examples of a production method include a method of applying heat at a thermal softening point or more to soften and stretch the resin, a method of applying the resin on a supporting substrate to heat and cure the resin, and the like. Examples of the insulative resin film include PET (polyethylene terephthalate), PEN (polyethylene naphthalate), PBT (polybutylene terephthalate), PEEK (polyether etherketone), PPS (polyphenylene sulfide), PI (polyimide), and the like.

In view of the property, easiness of availability, and cost, a polyester resin derivative film is preferably used, and specifically, a PET film is more preferably used. It is also necessary to properly choose the type according to the environment under which the thermally conductive composite sheet is used. For example, when the sheet is used in an environment exceeding 150°C for a long time, it is preferable to choose a PPS film or a PI film in view of thermal resistance.

### Thickness of Insulative Resin Film

The thickness of the insulative resin film is characterized to be 10 um or more and 50 um or less, and preferably 20 um or more and 40 um or less. If the thickness is less than 10 µm, sufficient slidability cannot be provided. On the other hand, when the thickness exceeds 50 µm, heat generated from a heat-generating electronic component cannot be efficiently transferred to a cooling member. The thickness of the insulative resin film is preferably as thin as possible because an insulative resin film generally has low thermal conductivity, and thus hinders heat transfer. However, if the insulative resin film is too thin, sufficient slidability cannot be obtained.

### Elastic Modulus of Insulative Resin Film

The elastic modulus of the insulative resin film is preferably 1 GPa or more, more preferably 2 GPa or more, and more preferably 3 GPa or more. The upper limit of the elastic modulus is not particularly limited, and may be, for example, 10 GPa or less, preferably 7 GPa or less, and more preferably 5 GPa or less. If the elastic modulus is less than 1 GPa, the strength of the resin film is insufficient, and sufficient slidability cannot be provided. In the present invention, the elastic modulus may be a value measured in accordance with ASTM D882.

### Method for Forming Thermally Conductive Composite Sheet

The thermally conductive composite sheet can be formed by, for example, laminating the insulative resin film on the thermally conductive sheet. In this case, it is preferable that an air layer is not entered at an interface between the thermally conductive sheet and the insulative resin film. Alternatively, a method of applying an uncured thermally conductive silicone composition on the insulative resin film, and heating and curing the composition, may be used. However, the method for forming the thermally conductive composite sheet is not limited to these methods. In addition, primer treatment or plasma treatment may be performed on the insulative resin film for improving adhesion between the thermally conductive sheet and the insulative resin film.

### Thermally Conductive Silicone Composition

The thermally conductive silicone composition for forming the thermally conductive sheet used in the present invention preferably contains, but not particularly limited to, the following components (A) to (D). Hereinbelow, each component will be described in detail.

### (A) Organopolysiloxane

The alkenyl group-containing organopolysiloxane of the component (A) is an organopolysiloxane having two or more alkenyl groups bonded to silicon atoms in one molecule, and gives a base of the cured product of the present composition. Generally, the main chain of the organopolysiloxane is basically composed of repeating diorganosiloxane units. A branched structure may be contained in a part of the molecular structure, or the molecule may be cyclic. A linear diorganopolysiloxane is preferred in view of the physical properties such as the mechanical strength of the cured product.

Examples of the alkenyl group bonded to a silicon atom include alkenyl groups having 2 to 8 carbon atoms, such as a vinyl group, an allyl group, a propenyl group, an isopropenyl group, a butenyl group, a hexenyl group, and a cyclohexenyl group. Among them, lower alkenyl groups such as a vinyl group and an allyl group are preferable, and a vinyl group is particularly preferable.

Examples of a functional group other than the alkenyl group bonded to a silicon atom include monovalent hydrocarbon groups selected from an alkyl group having 1 to 12, preferably 1 to 7 carbon atoms; an aryl group having 6 to 15, preferably 6 to 12 carbon atoms; and an aralkyl group having 7 to 15, preferably 7 to 12 carbon atoms. Examples of the alkyl group include a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, a dodecyl group, and the like. A cycloalkyl group such as a cyclopentyl group, a cyclohexyl group, and a cycloheptyl group may also be included. Examples of the aryl group include a phenyl group, a tolyl group, a xylyl group, a naphthyl group, and a biphenylyl group. Examples of the aralkyl group include a benzyl group, a phenylethyl group, a phenyl propyl group, a methyl benzyl group, and the like. Among these, preferred are a methyl group, an ethyl group, a propyl group, and a phenyl group. All of the functional groups may be the same or may be different.

The kinematic viscosity of the organopolysiloxane at 25°C is preferably in the range of 10 to 30,000 mm²/s, and more preferably 50 to 1,000 mm²/s. When the organopolysiloxane having the kinematic viscosity within this range is used, fluidity of the obtained composition is not impaired, and the thermally conductive filler can be easily filled. Note that the kinematic viscosity as used herein refers to a kinematic viscosity measured at 25°C using a Cannon-Fenske viscometer described in JIS Z 8803:2011.

The organopolysiloxane of the component (A) may be used alone, or two or more organopolysiloxanes having different viscosities may be used in combination.

### (B) Organohydrogen Polysiloxane

The organohydrogen polysiloxane of the component (B) is an organohydrogen polysiloxane having two or more on average, preferably 2 to 100 hydrogen atoms directly bonded to silicon atoms (hydrosilyl groups) in one molecule, and is a component that acts as a crosslinking agent of the component (A). That is, the hydrosilyl group in the component (B) and the alkenyl group in the component (A) are added by a hydrosilylation reaction, which is promoted by the platinum group metal-based curing catalyst of the component (D) described below, to give a three-dimensional network structure having a crosslinked structure. Note that when the number of hydrosilyl groups is less than 2 per molecule, curing does not occur.

Preferably used organohydrogen polysiloxane is represented by, but is not limited to, the following average structural formula (4), 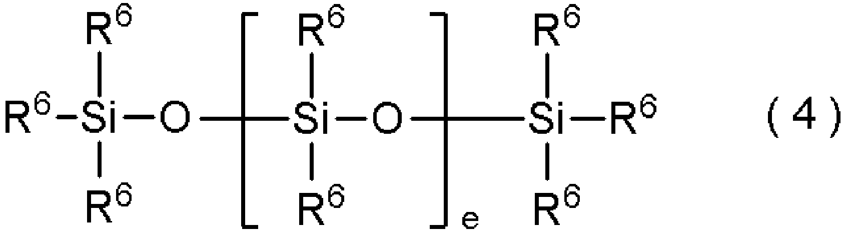 wherein R⁶ independently represents a hydrogen atom or a group selected from an alkyl group having 1 to 10 carbon atoms, an aryl group having 6 to 15 carbon atoms, and an aralkyl group having 7 to 15 carbon atoms; 2 or more, preferably 2 to 10 of R⁶ are hydrogen atoms; and "e" represents an integer of 1 or more, preferably 10 to 200.

In the formula (4), examples of the group other than the hydrogen atom of R⁶ include an alkyl group having 1 to 12, preferably 1 to 7 carbon atoms, an aryl group having 6 to 15, preferably 6 to 12 carbon atoms, and an aralkyl group having 7 to 15, preferably 7 to 12 carbon atoms. Examples of the alkyl group include a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, a dodecyl group, and the like. A cycloalkyl group such as a cyclopentyl group, a cyclohexyl group, and a cycloheptyl group may also be included. Examples of the aryl group include a phenyl group, a tolyl group, a xylyl group, a naphthyl group, a biphenylyl group, and the like. Examples of the aralkyl group include a benzyl group, a phenylethyl group, a phenyl propyl group, a methyl benzyl group, and the like. Preferred are a methyl group, an ethyl group, a propyl group, and a phenyl group. All of R⁶ may be the same or may be different.

The component (B) is added in such an amount that the amount of the hydrosilyl group derived from the component (B) is preferably 0.1 to 5.0 moles, more preferably 0.3 to 2.0 moles, and further preferably 0.5 to 1.0 mole relative to 1 mole of the alkenyl group derived from the component (A). When the amount of the hydrosilyl group derived from the component (B) is 0.1 mole or more relative to 1 mole of the alkenyl group derived from the component (A), the composition is cured. The obtained cured product has sufficient strength, can hold its shape as a formed body, and thus handling thereof is easy. Further, when the addition amount is 5.0 moles or less, flexibility of the cured product can be maintained, and the cured product does not become brittle.

### (C) Thermally Conductive Filler

The thermally conductive filler of the component (C) preferably mainly contains alumina, and comprises the following (C-i) to (C-iii) components, for example:
(C-i) irregular-shaped alumina with an average particle diameter of 10 to 30 um;
(C-ii) spherical alumina with an average particle diameter of 30 to 85 µm; and
(C-iii) an insulative inorganic filler with an average particle diameter of 0.1 to 6 µm.

In the present invention, the above average particle diameter is a value of volume-based cumulative average particle diameter (median diameter), which is measured by a laser diffraction scattering method (micro-track method), using a particle size analyzer Microtrac MT3300EX manufactured by Microtrac BEL Corp.

The irregular-shaped alumina of the component (C-i) can superiorly improve the thermal conductivity. The average particle diameter of the irregular-shaped alumina is preferably 10 to 30 µm, more preferably 15 to 25 um. When the average particle diameter is 10 um or more, an effect of improving the thermal conductivity is sufficiently high, the composition viscosity does not increase, and thus processability becomes satisfactory. Further, when the average particle diameter is 30 um or less, wear of a reaction pod or stirring blade hardly occurs, and there is no fear that insulation property of the composition decreases. The irregular-shaped alumina of the component (C-i) may be used alone or in combination of two or more. As the irregular-shaped alumina, an ordinary commercially available product can be used.

The spherical alumina of the component (C-ii) improves thermal conductivity of the composition, inhibits contact between the irregular-shaped alumina and a reaction pod or stirring blade, and provides a barrier function for suppressing wear of equipment. The average particle diameter of the spherical alumina is preferably 30 to 85 µm, and more preferably 40 to 80 um. When the average particle diameter is 30 um or more, it is possible to obtain sufficient barrier function, and wear of the reaction pod or stirring blade caused by irregular-shaped particles can be reduced. Meanwhile, when the average particle diameter is 85 um or less, alumina is not precipitated in the composition and uniformity of the composition is not impaired. The spherical alumina of the component (C-ii) may be used alone or in combination of two or more. As the spherical alumina, an ordinary commercially available product can be used.

The insulative inorganic filler of the component (C-iii) serves to improve thermal conductivity of the composition, but the main function is to adjust the viscosity, prevent precipitation, improve smoothness, and improve filling property of the composition. In addition, the insulative inorganic filler also serves to color, improve flame retardancy, improve strength, and improve permanent compression set. The filler preferably has insulation property to ensure the insulation property of the composition. The average particle diameter of the component (C-iii) is preferably 0.1 to 6 µm, and more preferably 0.5 to 4 um for exerting the above-mentioned properties. When the average particle diameter is 0.1 um or more, the composition viscosity is sufficiently low, and the formability becomes satisfactory. Further, when the average particle diameter is 6 um or less, smoothness of the composition is not impaired, and precipitation of the filler does not proceed rapidly, so that the thermal conductivity of formed body and formability of the composition become satisfactory.

As the insulative inorganic filler of the component (C-iii), for example, metal oxides such as alumina other than the above-mentioned components (C-i) and (C-ii), silica, magnesia, red iron oxide, beryllia, titania, and zirconia; metal nitrides such as aluminum nitride, silicon nitride, and boron nitride; metal hydroxides such as aluminum hydroxide and magnesium hydroxide; artificial diamond, and the like may be used. The filler may be spherical or irregular-shaped, and may be used alone or in combination of two or more. As the insulative inorganic filler, an ordinary commercially available product can be used.

An amount of the component (C-i) blended is preferably 500 to 1,500 parts by mass, and more preferably 700 to 1,200 parts by mass relative to 100 parts by mass of the component (A). When the blending amount is 500 parts by mass or more, the thermal conductivity is sufficiently improved, and when it is 1,500 parts by mass or less, fluidity of the composition is not lost, and the formability can be maintained. Furthermore, wear of a reaction pod or stirring blade hardly occurs, and there is no fear that insulation property of the composition decreases.

An amount of the component (C-ii) blended is preferably 150 to 4,000 parts by mass, and more preferably 200 to 3,000 parts by mass relative to 100 parts by mass of the component (A). When the blending amount is 150 parts by mass or more, the thermal conductivity is sufficiently improved, and when it is 4,000 parts by mass or less, fluidity of the composition is not lost, and the formability can be maintained.

An amount of the component (C-iii) blended is preferably 500 to 2,000 parts by mass, more preferably 600 to 1,800 parts by mass relative to 100 parts by mass of the component (A). When the blending amount is 500 parts by mass or more, smoothness of the composition is not impaired, or precipitation of the filler does not proceed rapidly, so that the thermal conductivity of a formed body and formability of the composition can be maintained. When the blending amount is 2,000 parts by mass or less, the composition viscosity does not increase significantly, and thus the formability can be maintained.

Further, an amount of the component (C) blended (that is, the total blending amount of the above components (C-i) to (C-iii)) is preferably 1,200 to 6,500 parts by mass, more preferably 1,500 to 5,500 parts by mass relative to 100 parts by mass of the component (A). When this blending amount is 1,200 parts by mass or more, the obtained composition has satisfactory thermal conductivity, the composition viscosity does not become too low, and the storage stability is sufficient. When this blending amount is 6,500 parts by mass or less, extensibility of the composition is sufficient, hardness is not too high, and a formed product having sufficient strength can be obtained.

By using the component (C) in the above blending ratio, the effect of the present invention described above can be achieved more advantageously and surely.

### (D) Platinum Group Metal-Based Curing Catalyst

The platinum group metal-based curing catalyst of the component (D) is a catalyst for promoting an addition reaction of the alkenyl group derived from the component (A) and a Si-H group derived from the component (B). Examples thereof include catalysts well-known for use in a hydrosilylation reaction.

Specific examples thereof include platinum group metal simple substances such as platinum (including platinum black), rhodium, and palladium; platinum chloride, chloroplatinic acid, and chloroplatinate such as H₂PtCl₄·nH₂O, H₂PtCl₆·nH₂O, NaHPtCl₆·nH₂O, KaHPtCl₆·nH₂O, Na₂PtCl₆·nH₂O, K₂PtCl₄·nH₂O, PtCl₄·nH₂O, PtCl₂, and Na₂HPtCl₄·nH₂O (wherein n represents an integer of 0 to 6, preferably 0 or 6); alcohol-modified chloroplatinic acid (refer to the specification of U.S. Patent No. 3,220,972); a complex of chloroplatinic acid and olefin (refer to the specifications of U.S. Patent No. 3,159,601, U.S. Patent No. 3,159,662, and U.S. Patent No. 3,775,452); a catalyst carrying a platinum group metal such as platinum black and palladium on a carrier such as alumina, silica, and carbon; a rhodium-olefin complex; chlorotris(triphenylphosphine)rhodium (Wilkinson catalyst); a complex of platinum chloride, chloroplatinic acid, or chloroplatinate and a vinyl group-containing siloxane, particularly a vinyl group-containing cyclic siloxane; and the like.

An amount of the component (D) used is preferably 0.1 to 2,000 ppm, more preferably 50 to 1,000 ppm relative to the component (A) in terms of mass of platinum group metal element.

### (E) Reaction Control Agent

Furthermore, in the thermally conductive silicone composition of the present invention, an addition reaction control agent can be used as a component (E). Examples of the addition reaction control agent that can be used includes, but is not particularly limited to, a known addition reaction control agent used for usual addition reaction-curable silicone compositions. Examples thereof include acetylene compounds such as 1-ethynyl-1-hexanol, 3-butyne-1-ol, and ethynyl methylidene carbinol, various nitrogen compounds, organophosphorus compounds, oxime compounds, organochloro compounds, and the like.

When the component (E) is blended, the amount of use is preferably 0.01 to 1 part by mass, and particularly preferably about 0.1 to 0.8 parts by mass relative to 100 parts by mass of the component (A). When the blending amount is 1 part by mass or less, the curing reaction proceeds well, and thereby the formation efficiency becomes favorable.

### (F) Surface Treatment Agent

The surface of the above component (C) is preferably subjected to hydrophobic treatment with a surface treatment agent (F). By hydrophobic treatment of the component (C), wettability between the component (C) and the organopolysiloxane of the component (A) is improved, and the thermally conductive filler of the component (C) can be uniformly dispersed in a matrix comprised of the component (A). In particular, the component (F) is preferably one or more selected from the group consisting of the component (F-1) and the component (F-2) described below.

The component (F-1) is an alkoxysilane compound represented by the following general formula (1),

R¹ₐR²_{b}Si(OR³)_{4-a-b} (1)

wherein R¹ independently represents an alkyl group having 6 to 15 carbon atoms, R² independently represents a monovalent hydrocarbon group having 1 to 12 carbon atoms, R³ independently represents an alkyl group having 1 to 6 carbon atoms, "a" represents an integer of 1 to 3, and "b" represents an integer of 0 to 2, provided that "a+b" is an integer of 1 to 3.

In the above general formula (1), examples of the alkyl group represented by R¹ include a hexyl group, an octyl group, a nonyl group, a decyl group, a dodecyl group, a tetradecyl group, and the like. When the number of carbon atoms of the alkyl group represented by R¹ satisfies the range of 6 to 15, wettability with the component (A) is sufficiently improved, handleability is excellent, and low temperature property of the composition becomes satisfactory.

Examples of the monovalent hydrocarbon group represented by R² include an alkyl group having 1 to 5, preferably 1 to 3 carbon atoms; an aryl group having 6 to 15, preferably 6 to 12 carbon atoms; and an aralkyl group having 7 to 15, preferably 7 to 12 carbon atoms. Examples of the alkyl group include a methyl group, an ethyl group, a propyl group, an isopropyl group, a butyl group, an isobutyl group, a tert-butyl group, a pentyl group, a neopentyl group, and the like. Examples of the aryl group include a phenyl group, a tolyl group, a xylyl group, a naphthyl group, a biphenylyl group, and the like. Examples of the aralkyl group include a benzyl group, a phenylethyl group, a phenyl propyl group, a methyl benzyl group, and the like. Among these, preferred are a methyl group, an ethyl group, a propyl group, and a phenyl group.

Examples of R³ include a methyl group, an ethyl group, a propyl group, a butyl group, a hexyl group, and the like.

The component (F-2) is a dimethyl polysiloxane with one molecular chain end blocked with a trialkoxysilyl group represented by the following general formula (2), 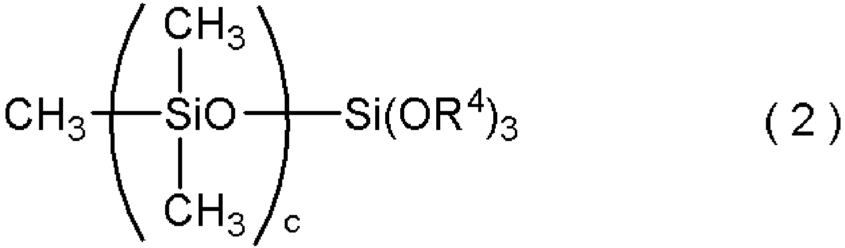 wherein R⁴ independently represents an alkyl group having 1 to 6 carbon atoms, and "c" represents an integer of 5 to 100.

In the above general formula (2), examples of the alkyl group represented by R⁴ include the same alkyl groups as represented by R³ in the above general formula (1). "c" represents an integer of preferably 5 to 70, particularly preferably 10 to 50.

For the surface treatment agent of the component (F), either one of the component (F-1) or component (F-2) may be used alone, or both of them may be used in combination.

When the component (F) is blended, the blending amount is preferably 0.01 to 300 parts by mass, particularly preferably 0.1 to 200 parts by mass relative to 100 parts by mass of the component (A). Oil separation is not induced when the ratio of the component (F) is 300 parts by mass or less.

### (G) Organopolysiloxane

In the thermally conductive silicone composition used in the present invention, it is possible to add the component (G) of an organopolysiloxane that has a kinematic viscosity at 23°C of 10 to 100,000 mm²/s and is represented by the following general formula (3), for the purpose of imparting properties such as adjusting viscosity of the thermally conductive silicone composition, 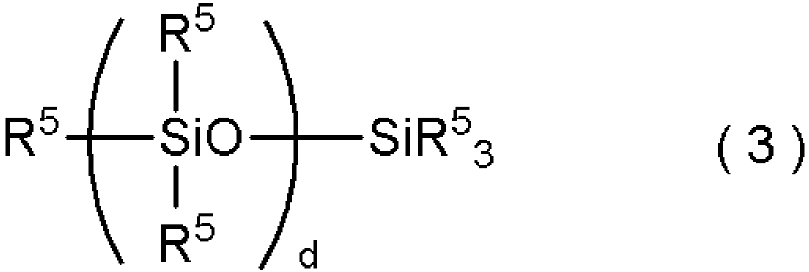 wherein R⁵ independently represents a monovalent hydrocarbon group having 1 to 12 carbon atoms and having no aliphatic unsaturated bond, and "d" represents an integer of 5 to 2,000. The component (G) may be used alone or in combination of two or more.

In the above general formula (3), R⁵ independently represents a monovalent hydrocarbon group having 1 to 12 carbon atoms and having no aliphatic unsaturated bond. Examples of R⁵ include alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenylyl group; and aralkyl groups such as a benzyl group, a phenylethyl group, a phenylpropyl group, and a methyl benzyl group. Representative examples include a group having 1 to 10 carbon atoms, and in particular, a group having 1 to 6 carbon atoms. Preferred are alkyl groups having 1 to 3 carbon atoms such as a methyl group, an ethyl group, and a propyl group; and a phenyl group. Particularly preferred are a methyl group and a phenyl group.

The above "d" preferably represents an integer of 5 to 2,000, and particularly preferably an integer of 10 to 10,000 in view of the required viscosity.

The kinematic viscosity of the component (G) at 23°C is preferably 10 to 100,000 mm²/s, and particularly preferably 100 to 10,000 mm²/s. When the kinematic viscosity is 10 mm²/s or more, a cured product of the resulting composition hardly causes oil bleeding. When the kinematic viscosity is 100,000 mm²/s or less, flexibility of the resulting thermally conductive silicone composition is sufficiently maintained.

When the component (G) is added to the thermally conductive silicone composition, the addition amount is not particularly limited, and may be an amount by which the desired effect can appear. It is preferably 0.1 to 100 parts by mass, more preferably 1 to 50 parts by mass relative to 100 parts by mass of the component (A). When the addition amount is within this range, favorable fluidity and operability can be easily maintained in the thermally conductive silicone composition before curing, and it is easy to load the thermally conductive filler of the component (C) into the composition.

### Method for Mounting Heat-Generating Electronic Component

Further, the present invention provides a method for mounting a heat-generating electronic component, comprising sliding the heat-generating electronic component on the insulative resin film of the thermally conductive composite sheet to align at an objective position, and then fixing the heat-generating electronic component.

In such a method for mounting a heat-generating electronic component, it is possible to mount the heat-generating electronic component by sliding without causing peeling or breakage of a thermally conductive sheet when the heat-generating electronic component in an electronic device is mounted, since one side of the sheet has excellent slidability. Such a method of mounting a component by sliding was impossible in conventional thermally conductive sheets. Thus, the range of the mounting method can be extended.

### EXAMPLE

Hereinafter, the present invention will be specifically described with reference to Examples and Comparative Examples. However, the present invention is not limited to the following Examples. Note that values of various parameters including the hardness, tack force, thermal conductivity, elastic modulus, kinematic viscosity, particle diameter, and the like, were measured by the method described above.

Thermally conductive sheets and insulative resin films used in Examples and Comparative Examples are shown below.

### Thermally Conductive Sheet

1 TC-100CAD-10 (manufactured by Shin-Etsu Chemical Co., Ltd., thickness: 1 mm, 3.2 W/mK, Asker C hardness: 10, tack force: 85 gf (0.834 N))
2 TC-100CAS-10 (manufactured by Shin-Etsu Chemical Co., Ltd., thickness: 1 mm, 1.8 W/mK, Asker C hardness: 10, tack force: 94 gf (0.922 N))
3 TC-50CAD-10 (manufactured by Shin-Etsu Chemical Co., Ltd., thickness: 0.5 mm, 3.2 W/mK, Asker C hardness: 10, tack force: 90 gf (0.883 N))
4 Thermally conductive sheet obtained by curing the composition shown below by the method of forming thermally conductive composite sheet 2 described below, having the thermal conductivity of 3.2 W/mK, Asker C hardness of 10, tack force of 90 gf (0.883 N), and thickness of 1 mm
5 TC-80TA-1 (manufactured by Shin-Etsu Chemical Co., Ltd., thickness: 0.8 mm, 1 W/mK, Asker C hardness: 90, tack force: 10 gf (0.098 N))

Components (A) to (G) making up the composition to provide the thermally conductive sheet 4 are as follows. A composition comprising:
A) 100 parts by mass of an organopolysiloxane represented by the following formula (5) and having a kinematic viscosity of 600 mm²/s, 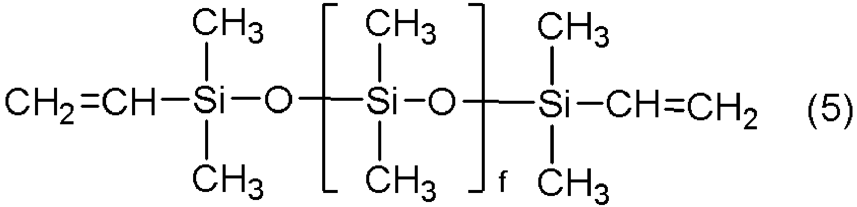 wherein "f" represents a number satisfying the above kinematic viscosity value;
B) 11 parts by mass of an organohydrogen polysiloxane represented by the following formula (6); 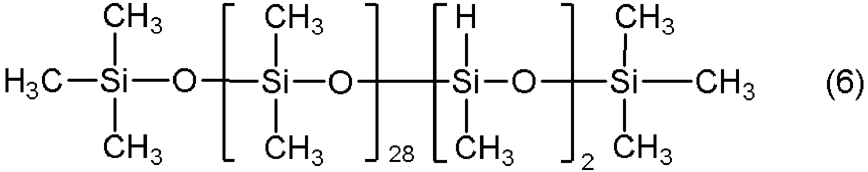
C)
   C-1) 230 parts by mass of irregular-shaped alumina with an average particle diameter of 1 µm,
   C-2) 470 parts by mass of irregular-shaped alumina with an average particle diameter of 5 µm,
   C-3) 800 parts by mass of irregular-shaped alumina with an average particle diameter of 20 µm,
   C-4) 120 parts by mass of spherical alumina with an average particle diameter of 45 µm, and
   C-5) 120 parts by mass of spherical alumina with an average particle diameter of 70 µm;
D) 1 part by mass of a 5 mass % chloroplatinic acid solution in 2-ethylhexanol;
E) 0.4 parts by mass of ethynyl methylidene carbinol;
F) 40 parts by mass of an organopolysiloxane represented by the following formula (7); and 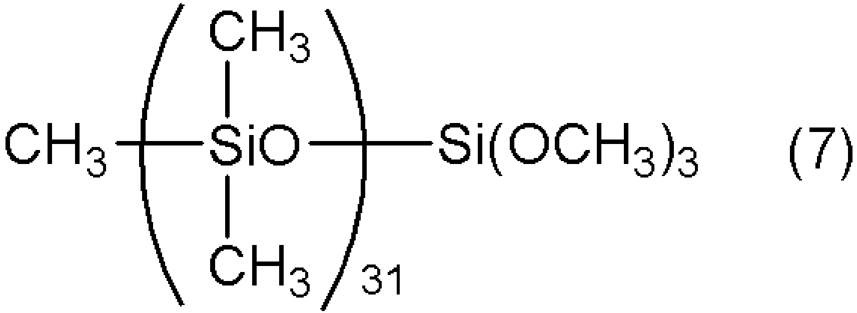
G) 15 parts by mass of an organopolysiloxane represented by the following formula (8).

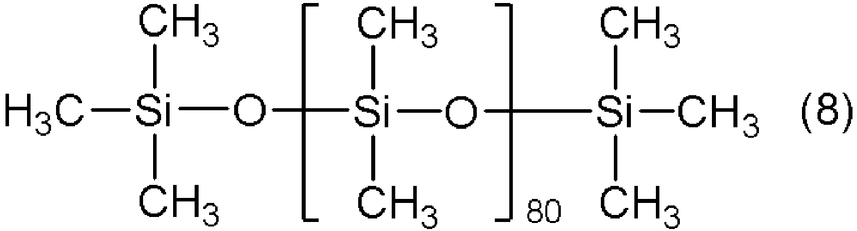

Physical property values of the thermally conductive sheet 4 obtained from the above composition were evaluated as follows.

### Evaluation Method

Thermal conductivity: The obtained composition was cured into a sheet with a thickness of 6 mm. Using the obtained two sheets, the thermal conductivity of the sheets was measured with a thermal conductivity measuring device whose product name is TPA-501, manufactured by Kyoto Electronics Manufacturing Co., Ltd.

Hardness: The obtained composition was cured into a sheet with a thickness of 6 mm. The obtained two sheets were stacked, and the hardness of the laminate was measured with an Asker C durometer.

### Insulative Resin Film

1 Lumirror S10 (manufactured by Toray Industries, Inc., PET, thickness: 38 um, elastic modulus: 4.7 GPa)
2 Lumirror S10 (manufactured by Toray Industries, Inc., PET, thickness: 24 um, elastic modulus: 4.7 GPa)
3 APICAL (manufactured by Kaneka Corporation, PI, thickness: 24 um, elastic modulus: 3.2 GPa)
4 Kapton (manufactured by DU PONT-TORAY CO., LTD., PI, thickness: 7.5 um, elastic modulus: 3.1 GPa)
5 TC-20TA-1 (manufactured by Shin-Etsu Chemical Co., Ltd., thermally conductive silicone rubber, thickness: 0.2 mm, elastic modulus: 13 MPa)
6 TORAYFAN (manufactured by Toray Industries, Inc., polypropyrene, thickness: 30 um, elastic modulus: 0.15 GPa)
7 Lumirror S10 (manufactured by Toray Industries, Inc., PET, thickness: 50 um, elastic modulus: 4.7 GPa)
8 Kapton (manufactured by DU PONT-TORAY CO., LTD., PI, thickness: 12.5 um, elastic modulus: 3.1 GPa)
9 Lumirror S10 (manufactured by Toray Industries, Inc., PET, thickness: 75 um, elastic modulus: 4.7 GPa)

### Examples 1 to 7 and Comparative Examples 1 to 7

Thermally conductive composite sheets were formed by laminating the thermally conductive sheets and the insulative resin films in the combination shown in Table 1 below. Methods for forming the thermally conductive composite sheets were as follows.

### Method for Forming Thermally Conductive Composite Sheet 1

On one side of the thermally conductive sheet, the insulative resin film was attached, and a 2 kg rubber roller was moved on the film from the end part at a rate of 0.5 m/min. Thereby, the thermally conductive sheet and the insulative resin film were bonded together without a gap. This technique was used in examples in which the above thermally conductive sheets 1 to 3, and 5 were used.

### Method for Forming Thermally Conductive Composite Sheet 2

A composition comprised of an uncured silicone polymer and the thermally conductive filler was applied on the insulative resin film by a comma coater, and the composition was cured at 120°C for 20 minutes. This technique was applied in an example in which the above thermally conductive sheet 4 was used.

Slidability of the obtained films was evaluated, and the results were summarized in Table 1. The evaluation methods were as follows.

### Evaluation Method

Slidability: The thermally conductive composite sheet with a size of 200 x 500 mm was attached to a sufficiently large aluminum plate using a 2 kg rubber roller at a rate of 0.5 m/min. Then, a stainless-steel block having a width of 200 mm, length of 40 mm, height of 150 mm, and weight of 2kg moved on the insulative resin film by 500 mm at a rate of 1 m/min to observe whether sheet breakage or peeling occurred or not. The sheet was evaluated as "pass" when the sheet breakage or peeling did not occur, and the sheet was evaluated as "fail" when the sheet breakage or peeling occurred. Thermal resistance increase value: The value was determined as a difference between thermal resistance of the thermally conductive sheet and thermal resistance of the thermally conductive composite sheet in which the insulative resin film was laminated. Measurement method was in accordance with ASTM D5470, and the measurement was performed under a condition of 50°C/40 psi.

**[Table 1]**

| Examples | 1 | 2 | 3 | 4 | 5 | 6 | 7 |
|---|---|---|---|---|---|---|---|
| Thermally conductive sheet | 1 | 2 | 3 | 4 | 2 | 1 | 2 |
| Insulative resin film | 1 | 2 | 1 | 2 | 3 | 7 | 8 |
| Thermal resistance increase value (cm²-K/W) | 2.2 | 1.2 | 2.2 | 1.2 | 1.0 | 2.8 | 0.4 |
| Slidability evaluation | Pass | Pass | Pass | Pass | Pass | Pass | Pass |
| Comparative Examples | 1 | 2 | 3 | 4 | 5 | 6 | 7 |
| Thermally conductive sheet | 1 | 2 | 1 | 3 | 5 | 1 | 1 |
| Insulative resin film | None | 4 | 5 | 6 | 1 | 1 (Both sides) | 9 |
| Thermal resistance increase value (cm²-K/W) | 0 | 0.7 | 2.9 | 1.4 | 2.2 | 4.8 | 4.2 |
| Slidability evaluation | Fail | Fail | Fail | Fail | Fail | Not perform -able | Pass |

Examples 1 to 7 in which the thermally conductive composite sheet of the present invention was used showed excellent slidability, and the sheet or film was not broken. Thus, it was confirmed that the thermally conductive composite sheet of the present invention can be suitably used for mounting a heat-generating electronic component.

Contrarily, as in Comparative Example 1, when the insulative resin film was not included, the sheet was broken due to stickiness of the sheet, and the slidability evaluation was failed. In Comparative Example 2, the insulative resin film was too thin, and thus the film was broken. In Comparative Example 3, elastic modulus of the silicone rubber was insufficient, and TC-20TA-1 was broken. In Comparative Example 4, a polypropyrene film having low elastic modulus was elongated, and then broken. Thus, the slidability evaluation was failed. In Comparative Example 5, hardness of the thermally conductive sheet was high, and the tack force was not sufficient, so that the insulative resin film was peeled off. In Comparative Example 6, the insulative resin film was laminated on both sides of the thermally conductive sheet. However, the resulting sheet could not be attached to an aluminum plate, and the slidability evaluation itself could not be performed. In Comparative Example 7, the thick insulative resin film was used. Therefore, the resulting sheet passed the slidability test, but the thermal resistance increase value was high.

It should be noted that the present invention is not limited to the above-described embodiments. The embodiments are just examples, and any examples that substantially have the same configuration and demonstrate the same functions and effects as those in the technical concept disclosed in claims of the present invention are included in the technical scope of the present invention.

## Claims

1. A thermally conductive composite sheet, comprising:
a thermally conductive sheet containing an organopolysiloxane elastomer and a thermally conductive filler, and having an Asker C hardness of 30 or less, surface tack force of 30 gf (0.294 N) or more, a thickness of 0.3 mm or more, and a thermal conductivity of 0.8 W/mK or more; and
an insulative resin film having a thickness of 10 um or more and 50 um or less and an elastic modulus of 1 GPa or more,
wherein the insulative resin film is laminated on one side of the thermally conductive sheet.

2. The thermally conductive composite sheet according to claim 1,
wherein the insulative resin film is a polyester resin film.

3. The thermally conductive composite sheet according to claim 1 or 2,
wherein the thermally conductive sheet has a thermal conductivity of 3.0 W/mK or more.

4. The thermally conductive composite sheet according to any one of claims 1 to 3,
wherein the thermally conductive sheet is a cured product of a thermally conductive silicone composition containing following components (A) to (D):
(A) 100 parts by mass of an organopolysiloxane having two or more alkenyl groups in one molecule;
(B) an organohydrogen polysiloxane having two or more hydrogen atoms directly bonded to silicon atoms in such an amount that a molar number of the hydrogen atom directly bonded to the silicon atom is 0.1 to 5.0 times a molar number of the alkenyl group derived from the component (A);
(C) 1,200 to 6,500 parts by mass of the thermally conductive filler; and
(D) 0.1 to 2,000 ppm of a platinum group metal-based curing catalyst relative to the component (A) in terms of mass of a platinum group metal element.

5. The thermally conductive composite sheet according to claim 4,
wherein the thermally conductive filler of the component (C) comprises following three components:
(C-i) 500 to 1,500 parts by mass of irregular-shaped alumina with an average particle diameter of 10 to 30 um;
(C-ii) 150 to 4,000 parts by mass of spherical alumina with an average particle diameter of 30 to 85 µm; and
(C-iii) 500 to 2,000 parts by mass of an insulative inorganic filler with an average particle diameter of 0.1 to 6 µm.

6. The thermally conductive composite sheet according to claim 4 or 5,
wherein the component (C) is a treated filler with one or more of following (F) surface treatment agents selected from a group consisting of:
(F-1) an alkoxysilane compound represented by a following general formula (1),
R¹ₐR²_{b}Si(OR³)_{4-a-b} (1)
wherein R¹ independently represents an alkyl group having 6 to 15 carbon atoms, R² independently represents a monovalent hydrocarbon group having 1 to 12 carbon atoms, R³ independently represents an alkyl group having 1 to 6 carbon atoms, "a" represents an integer of 1 to 3, and "b" represents an integer of 0 to 2, provided that "a+b" is an integer of 1 to 3; and
(F-2) a dimethyl polysiloxane with one molecular chain end blocked with a trialkoxysilyl group represented by a following general formula (2), 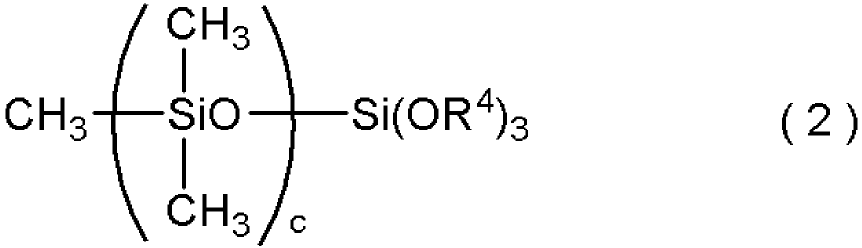
wherein R⁴ independently represents an alkyl group having 1 to 6 carbon atoms, and "c" represents an integer of 5 to 100.

7. The thermally conductive composite sheet according to claim 6,
wherein an amount of the component (F) blended is 0.01 to 300 parts by mass relative to 100 parts by mass of the component (A).

8. A method for mounting a heat-generating electronic component, comprising sliding the heat-generating electronic component on the insulative resin film of the thermally conductive composite sheet according to any one of claims 1 to 7 to align at an objective position, and then fixing the heat-generating electronic component.
